# DEMANDE DE BREVET EUROPEEN

(11) **EP 4 749 520 A1**
(43) Date de publication de la demande: **27.05.2026**
(21) Numéro de dépôt: 25209725.8
(22) Date de dépôt: 20.10.2025
(51) Int. Cl.: G06N 3/006, G06N 20/00

(54) **MÉTHODE D'ANALYSE D'ACTIVITÉ HUMAINE NON INTRUSIVE DANS UN ENVIRONNEMENT CONNECTÉ**

(30) Priorité: 25.11.2024 FR 2412960
(71) Demandeur: Orange, 92130 Issy-les-Moulineaux (FR)
(72) Inventeur: FOULONNEAU, Anthony, 92326 CHATILLON CEDEX (FR); LACOCHE, Jérémy, 92326 CHATILLON CEDEX (FR)
(74) Mandataire: Plasseraud IP

(57) **Abrégé**

Il est proposé un procédé de détermination d'une activité humaine dans un environnement comportant au moins un capteur d'utilisation d'au moins un équipement de l'environnement, le procédé comportant un apprentissage par une intelligence artificielle et une inférence de l'intelligence artificielle pour déterminer l'activité humaine dans ledit environnement, caractérisé en ce que le procédé comporte, pour l'apprentissage de l'intelligence artificielle :
- une génération de données d'entrainement de l'intelligence artificielle, à partir d'une simulation d'une activité d'au moins un agent autonome évoluant dans une simulation d'environnement générée à partir d'un jumeau numérique de l'environnement réel et utilisant au moins une réplique numérique dudit équipement.

## Description

### Domaine technique

La présente divulgation relève du domaine de l'analyse de mesures de capteurs, et plus particulièrement est relative au domaine de l'analyse d'activités humaines dans un environnement équipé de capteurs.

### Technique antérieure

L'Internet des objets (loT) permet d'interconnecter les appareils équipant les bâtiments, maisons, locaux, afin d'échanger entre eux des données mesurées dans leur environnement. Dans ces environnements connectés, il arrive alors que des dizaines, voire des centaines, de capteurs soient déployés pour enregistrer des données variées, notamment pour des applications de sécurité des utilisateurs et de surveillance des environnements. Ces applications soulèvent des problématiques de respect de la vie privée des utilisateurs, car impliquent généralement la collecte et l'analyse potentiellement intrusives de données d'identification personnelle, parfois à l'insu des utilisateurs.

Afin de contourner ces problèmes, des méthodes se sont développées et privilégient l'analyse de données enregistrées par des capteurs dits « non-intrusifs », c'est-à-dire des capteurs qui ne permettent pas à eux-seuls d'identifier un individu ou un utilisateur ni à enregistrer ses informations personnelles. Ceux-ci sont par exemple des capteurs de mesures physiques environnementales (pression, température, humidité), d'activation d'équipements (prises électriques, allumage d'une lampe), etc., qui ne permettent pas de rapprocher ces informations à un utilisateur en particulier. En revanche, ces mesures non-intrusives ne constituent pas en elles-mêmes des données permettant d'analyser un type d'activité humaine, et ne sont pas utilisables directement pour aider à la surveillance et à la sécurité d'utilisateurs.

Des travaux en intelligence artificielle (IA) ont ainsi cherché à exploiter ces données fournies par les capteurs non-intrusifs pour produire des informations pertinentes pour déduire l'activité d'utilisateurs dans les environnements connectés. Classiquement, ces méthodes requièrent de prévoir une phase d'apprentissage des algorithmes d'IA, en général de manière supervisée, qui s'appuient sur des données d'entrainement produites par les capteurs lors de l'activité d'opérateurs évoluant dans l'environnement connecté.

Cette phase d'apprentissage est néanmoins très dépendante de l'environnement connecté et des capteurs qui l'équipent. Un algorithme entrainé dans un environnement donné se montrera ainsi inefficace dans un autre avec d'autres types de capteurs disposés différemment, ou dans le cas où l'environnement lui-même présente une topologie singulière. De plus, la création de ces données d'entrainement est très longue et coûteuse, et peut requérir plusieurs jours d'enregistrement de données, où un ou plusieurs opérateurs vivent dans l'environnement connecté et annotent toutes leurs activités pour l'entraînement de l'IA.

Une autre approche peut permettre d'éviter la mobilisation d'opérateurs humains dans l'environnement cible pendant plusieurs jours, en proposant une simulation d'activité humaine dans une copie de l'environnement, où la géométrie de l'environnement et la disposition des capteurs sont modélisées en 3D. Le comportement des capteurs est également simulé. Un agent virtuel, ou « agent autonome », qui se comporte comme un humain le ferait dans l'environnement réel, y est ensuite implémenté et « vit » dans la copie de l'environnement pendant plusieurs semaines. La simulation d'activité de l'agent autonome se déroule à un rythme accéléré, ce qui permet de réduire le temps de production des données d'entraînement.

Néanmoins, cette méthode demeure partiellement automatisée et nécessite de nombreuses interventions humaines, parfois fastidieuses. Dans celle-ci, les opérateurs doivent produire les données d'entraînement à partir de la simulation d'activité, et ensuite les implémenter pour l'entraînement de l'algorithme, puis surveiller son bon déroulement. De plus, la création de l'environnement 3D requiert une cartographie précise, qui est réalisée manuellement avant le début de la simulation.

### Résumé

La présente divulgation vient améliorer la situation.

Il est proposé un procédé de détermination d'une activité humaine dans un environnement comportant au moins un capteur d'utilisation d'au moins un équipement de l'environnement, le procédé comportant un apprentissage par une intelligence artificielle et une inférence de l'intelligence artificielle pour déterminer l'activité humaine dans ledit environnement, caractérisé en ce que le procédé comporte, pour l'apprentissage de l'intelligence artificielle :
- une génération de données d'entrainement de l'intelligence artificielle, à partir d'une simulation d'une activité d'au moins un agent autonome évoluant dans une simulation d'environnement générée à partir d'un jumeau numérique de l'environnement réel et utilisant au moins une réplique numérique dudit équipement.

Une telle réalisation permet ainsi d'automatiser totalement le processus de création d'une réplique de l'environnement réel ainsi que celui de génération de données d'entraînement. Aucune intervention humaine n'est nécessaire, les données étant générées et automatiquement annotées à partir des interactions de l'agent virtuel autonome avec les répliques de l'environnement et des équipements, de la même manière qu'un utilisateur humain interagirait dans un environnement réel et avec des équipements de l'environnement.

L'agent virtuel autonome est ainsi simulé de manière à interagir librement ou au moins partiellement librement avec la réplique d'environnement, sans nécessiter d'interventions humaines. Un tel agent autonome permet ainsi de s'affranchir du recours à un enregistrement préalable d'activités humaines réalisées par des opérateurs.

On entend par « inférence de l'intelligence artificielle » la sortie produite par l'intelligence artificielle en réponse à une activité dans l'environnement réel. Cette sortie peut être notamment une identification d'un comportement humain.

Dans une réalisation, l'inférence de l'intelligence artificielle peut être mise en œuvre sur la base de données captées pendant l'utilisation dudit au moins un équipement par au moins un utilisateur physique, en connaissance des données d'entrainement acquises à partir d'utilisations simulées de la réplique numérique de l'équipement par ledit au moins un agent autonome.

Ainsi, dans cette réalisation, l'intelligence artificielle, qui a été entraînée à partir de la simulation d'activité de l'agent autonome évoluant dans la réplique de l'environnement réel, est mise en œuvre dans l'environnement réel avec l'utilisateur physique réel, et produit avantageusement des inférences précises et identifie correctement le comportement humain et l'activité humaine.

Dans une réalisation, l'au moins un agent autonome utilisé pour la génération des données d'entrainement est choisi en fonction d'un profil de l'au moins un utilisateur physique.

Dans cet exemple, l'agent autonome est ainsi configuré de manière à imiter le comportement de l'utilisateur dans son environnement réel. En reproduisant alors de manière plus fidèle le comportement de l'utilisateur, l'agent autonome génère des données d'entraînement plus pertinentes pour l'intelligence artificielle, ce qui améliore d'autant plus la précision de ses inférences.

Dans une réalisation, le jumeau numérique de l'environnement réel est initialisé préalablement à la génération de données d'entrainement de l'intelligence artificielle, ledit jumeau numérique étant configuré pour reproduire un état et un comportement de l'environnement réel par la simulation d'environnement dudit environnement réel comprenant la réplique numérique dudit au moins un équipement de l'environnement réel.

Selon un mode de réalisation, le jumeau numérique est généré à partir de données de l'environnement réel, parmi au moins :
- un type de local professionnel ou domestique,
- une surface dudit local,
- des espaces fonctionnels dans ladite surface, et des types de fonctions desdits espaces,
- un état dudit local.

Le jumeau numérique est donc élaboré à partir d'un ensemble d'informations et de données pour être le plus fidèle possible à l'environnement réel, à ses équipements et à leur comportement.

Selon un autre aspect, ledit au moins un équipement de l'environnement réel comprend au moins :
- un capteur d'ouverture et/ou de fermeture d'une arrivée d'eau ;
- un capteur d'une prise connectée ;
- un capteur de présence ;
- un capteur de pression ;
- un capteur d'allumage et/ou d'extinction d'une lumière ;
- un capteur de mouvement de porte, de store, de volet, et/ou de fenêtre ;
- un capteur thermostatique ;
- un capteur d'utilisation d'un appareil électroménager, et/ou ;
- un capteur d'utilisation d'un terminal connecté.

En outre, selon une réalisation, ledit au moins un capteur est relié à un réseau local animé par une passerelle connectée à un serveur via un réseau étendu.

Une telle réalisation exploite toutes ou parties des mesures et informations captées par les capteurs non intrusifs pouvant équiper l'environnement réel, qui sont non-intrusives, impersonnelles, indirectement liées à l'activité humaine, et n'étant pas suffisantes à elles seules pour identifier un utilisateur.

Selon une réalisation, le procédé de la présente divulgation peut comporter en outre une étape de contrôle d'efficacité de l'intelligence artificielle,
dans laquelle l'inférence de l'intelligence artificielle est mise en œuvre sur la base de données captées pendant la simulation de l'activité de l'au moins un agent autonome évoluant dans la simulation de l'environnement générée à partir du jumeau numérique de l'environnement réel, en connaissance des données d'entrainement acquises à partir d'utilisations simulées de la réplique numérique de l'équipement par l'au moins un agent autonome,
dans laquelle une comparaison de l'inférence produite par l'intelligence artificielle par rapport à la simulation de l'activité de l'au moins un agent autonome est évaluée, et si la comparaison est supérieure à un seuil prédéfini, lesdites données d'entraînement sont corrigées par rapport auxdites données captées pendant la simulation de l'activité de l'au moins un agent autonome.

De plus, selon une réalisation possible, au moins un nouvel agent autonome peut être généré en fonction de ladite comparaison supérieure au seuil prédéfini pour générer de nouvelles données d'entraînement de l'intelligence artificielle.

Cette réalisation dans laquelle une étape de contrôle d'efficacité est implémentée permet d'améliorer d'autant plus les réponses produites par l'intelligence artificielle, qui peut par exemple être ré-entraînée plusieurs fois, avec un même agent autonome évoluant dans une même simulation 3D du même jumeau numérique générant une autre itération de données d'entraînement, ou bien être ré-entraînée dans un tout nouveau contexte, avec un (ou plusieurs) autre agent autonome (paramétré(s) différemment), une autre simulation 3D et/ou un autre jumeau numérique (avec d'autres équipements par exemple) générant un autre jeu de données d'entraînement, jusqu'à converger vers une efficacité satisfaisante (i.e. supérieure au seuil prédéfini).

Dans une réalisation, le procédé peut comporter une augmentation de vitesse d'évolution de l'au moins un agent autonome dans ladite simulation de l'environnement générée à partir du jumeau numérique, par rapport à une évolution réelle par au moins un utilisateur physique dans l'environnement réel, en vue d'accélérer la simulation d'activité par l'au moins un agent autonome, et de la génération de données d'entrainement.

L'agent autonome, la simulation en 3D du jumeau numérique et la simulation d'activité de l'agent peuvent être calculés par un ou plusieurs processeurs. Une telle réalisation du procédé, alors entièrement automatisé, augmente drastiquement la vitesse de l'entraînement de l'intelligence artificielle par rapport à un entraînement semi-automatique où des opérateurs humains évolueraient et annoteraient toutes leurs activités pendant plusieurs jours dans un environnement réel.

Selon une réalisation, chaque agent autonome peut évoluer dans ladite simulation de l'environnement en fonction d'une décision prise par l'agent autonome à partir d'un modèle de besoins de l'agent autonome.

Ainsi, l'agent autonome peut décider ou non de faire certaines activités, afin d'avoir un comportement plus réaliste et automatisé, et similaire à un comportement d'un utilisateur physique particulier.

Selon un autre aspect, il est également proposé un programme informatique comportant des instructions pour la mise en œuvre du procédé décrit dans la présente divulgation, lorsqu'elles sont exécutées par un circuit de traitement.

La présente divulgation est également relative à un dispositif pouvant comporter un circuit de traitement pour la mise en œuvre du procédé décrit.

Un tel dispositif peut être intégré à l'environnement réel, par exemple via une passerelle d'un réseau local de l'environnement (pour une solution d'analyse d'activité en local), ou être intégré à un serveur distant d'un réseau étendu (pour une analyse à distance par l'intelligence artificielle).

### Brève description des dessins

D'autres caractéristiques, détails et avantages apparaîtront à la lecture de la description détaillée ci-après, et à l'analyse des dessins annexés, sur lesquels :
**Fig. 1**

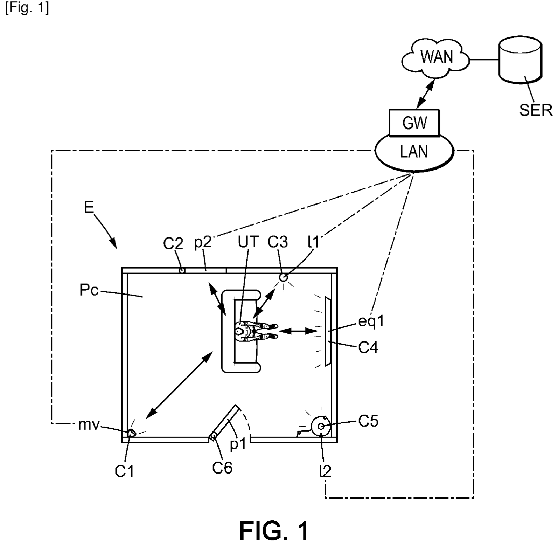

   [Fig. 1] illustre un exemple d'environnement réel comprenant des équipements et des capteurs interconnectés, et un utilisateur physique évoluant dans l'environnement réel.
**Fig. 2**

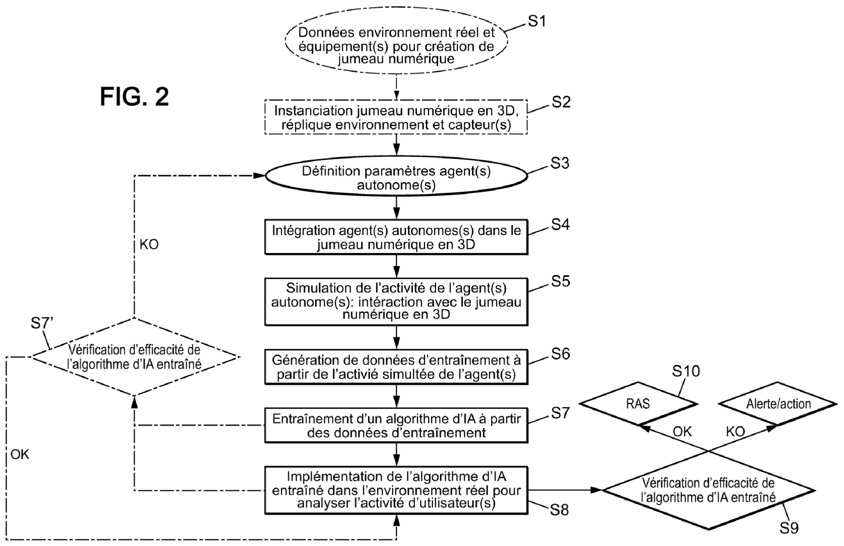

   [Fig. 2] montre un exemple d'étapes du procédé de la présente divulgation tel que défini ci-avant, pour analyser l'activité d'un utilisateur et identifier son comportement dans un environnement réel.
**Fig. 3**

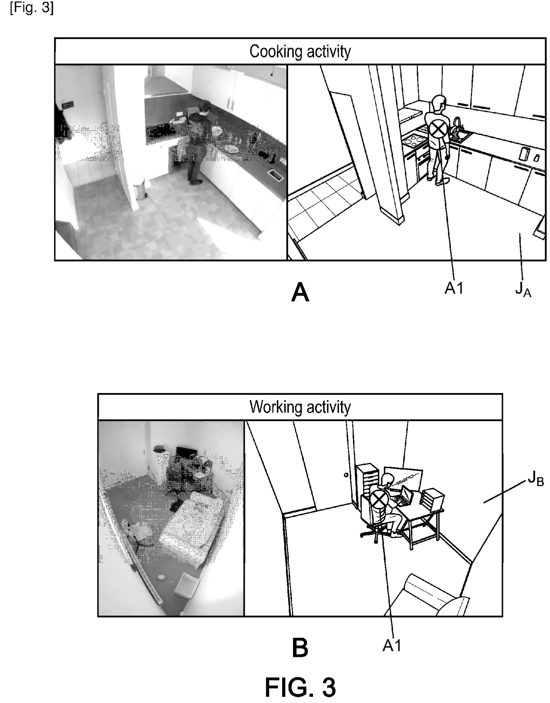

   [Fig. 3] montre deux exemples de comparaison entre une activité réelle d'un utilisateur physique dans un environnement réel (photographies en noir et blanc à gauche) et une activité simulée d'un agent autonome dans une reproduction de l'environnement réel (simulations à droite).
**Fig. 4**

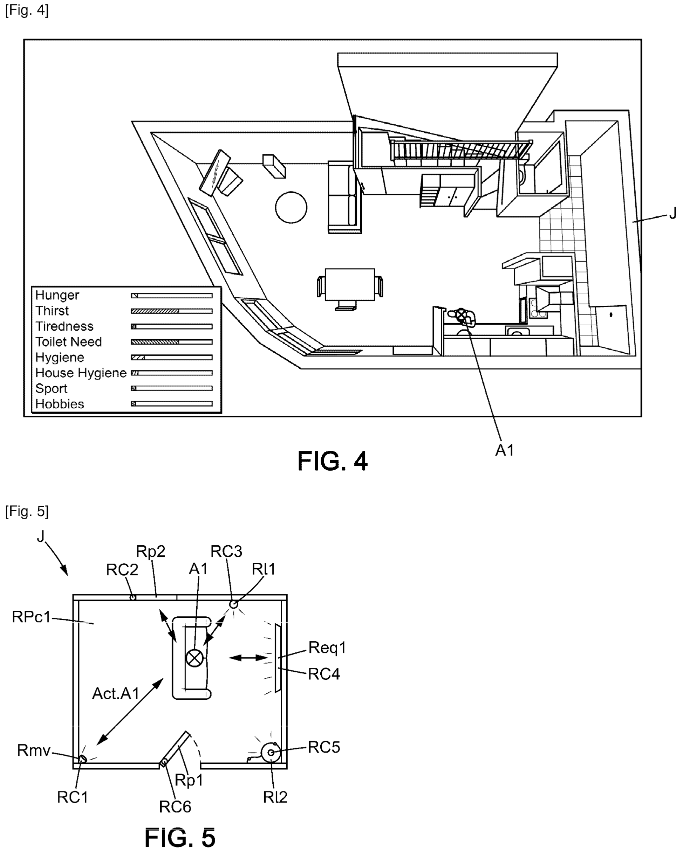

   [Fig. 4] illustre un exemple d'une simulation d'activité d'un agent autonome basé sur un modèle de besoins, selon un mode de réalisation.
**Fig. 5**
   [Fig. 5] montre un exemple d'une simulation 3D basée sur un jumeau numérique de l'environnement réel de la figure 1, dans lequel un agent autonome évolue, et mis en œuvre selon le procédé ci-avant.
**Fig. 6**

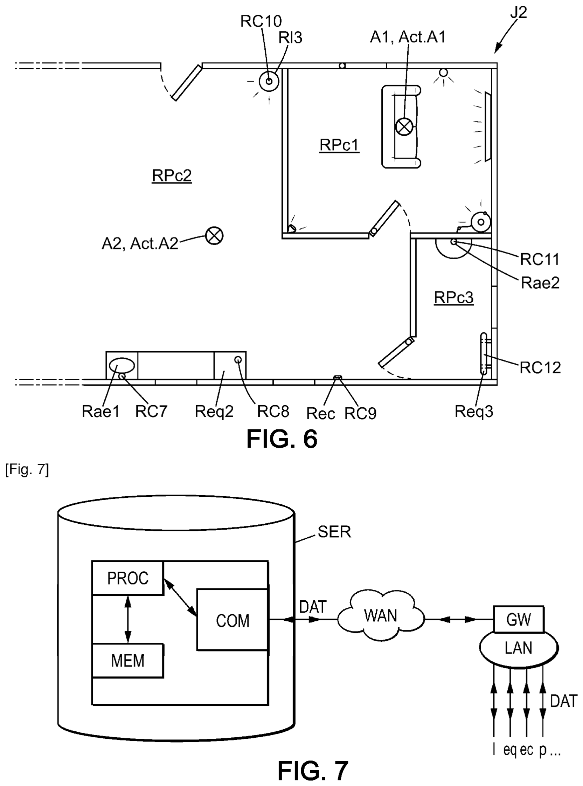

   [Fig. 6] illustre un autre exemple de reproduction par une simulation 3D basée sur un jumeau numérique d'un autre environnement réel comprenant plusieurs pièces, et dans lequel plusieurs agents autonomes évoluent, et mis en œuvre selon le procédé ci-avant.
**Fig.7**
   [Fig. 7] montre un exemple de circuit de traitement pour mettre en œuvre le procédé défini ci-avant, selon un mode de réalisation.

### Description des modes de réalisation

La figure 1 présente un exemple d'un environnement réel E, de type maison connectée, composé d'une pièce Pc et comprenant des équipements de vie variés. Un utilisateur physique UT évolue dans cet environnement et interagit avec les équipements. Dans l'exemple illustré, la pièce Pc comprend ainsi un téléviseur eq, un luminaire mural l1, une lampe à pied l2, une porte p, une fenêtre équipée d'un store p, un détecteur de mouvement mv, et chacun d'eux sont équipés par au moins un capteur C1 à C6, qui sont des capteurs non intrusifs. Les équipements peuvent être interconnectés via une passerelle GW d'un réseau local LAN de la maison. Les informations récoltées par la passerelle peuvent ensuite envoyées à destination d'un serveur SER via un réseau étendu WAN.

Dans cet exemple, l'utilisateur UT regarde un contenu multimédia sur le téléviseur eq, les lampes l1 et l2 de la pièce sont allumées, le store de fenêtre est fermé, la porte p de la pièce est ouverte et le capteur de mouvement mv détecte la présence de l'utilisateur dans la pièce. Les capteurs C1 à C6 enregistrent des mesures et informations relatives à ces équipements. Ils peuvent être activés ensemble ou séparément, en fonction des actions de l'utilisateur UT. Par exemple, le capteur C4 du téléviseur eq indique que le téléviseur est allumé et en fonctionnement et le capteur C2 de la fenêtre n'est pas en fonctionnement mais a enregistré une activation de l'abaissement du store à un instant donné.

L'environnement réel peut comprendre d'autres types de capteurs, pouvant enregistrer d'autres données pour ces mêmes équipements (e.g. un capteur du téléviseur pourrait aussi enregistrer une consommation électrique du téléviseur, un capteur de la fenêtre pourrait mesurer un rapport de luminosité intérieure et extérieure), et/ou d'autres capteurs pour d'autres équipements (non illustrés) qui seraient par exemple reliés aux prises électriques, ou pour mesurer des données physiques de l'environnement E, telles que la pression, la température, l'humidité de la pièce, l'heure, etc.

La liste suivante, non exhaustive, présente d'autres exemples de capteurs non intrusifs qui pourraient être installés dans l'environnement réel ; un capteur d'ouverture et/ou de fermeture d'une arrivée d'eau, un capteur de mesure de débit d'eau, un capteur d'utilisation d'une prise connectée, un capteur de présence ou de mouvement, un capteur de pression, un capteur d'allumage et/ou d'extinction d'une lumière, un capteur de mouvement de porte, de store, de volet, et/ou de fenêtre, un capteur thermostatique, un capteur d'utilisation d'un appareil électroménager/électronique, un capteur d'utilisation d'un terminal connecté, un capteur d'un routeur avec mesure du débit internet, un capteur d'humidité, un capteur de luminosité, un capteur de fumée, un capteur d'activité sonore...

Il pourrait aussi s'agir de capteurs de présence par « Wifi sensing », lorsqu'une atténuation d'un signal Wifi émis vers un équipement est enregistrée, pouvant marquer la présence d'un utilisateur entre l'équipement et un émetteur Wifi.

Néanmoins, les données collectées par ces capteurs non intrusifs ne suffisent pas, à elles seules, d'analyser ou de déduire précisément une activité humaine, notamment en ce qui concerne la sécurité des utilisateurs dans un environnement réel.

La solution proposée met alors en œuvre un procédé, pour exploiter et tirer parti de toutes les informations captées par de tels capteurs non intrusifs pour en déduire l'activité humaine, tout en évitant d'implémenter des dispositifs de surveillance « intrusifs », c'est-à-dire avec reconnaissance des personnes, comme des caméras ou micros et qui sont généralement utilisés pour l'analyse d'activité. Elle s'appuie pour cela sur l'utilisation d'un algorithme d'IA, entraîné sur une reproduction numérique fidèle de l'environnement et du comportement de l'utilisateur.

Ainsi, ce procédé, en plus de ne reposer avantageusement que sur des données non intrusives, est totalement automatisé et ne nécessite pas, ou peu, d'interventions de l'utilisateur au cours du processus.

Les étapes de ce procédé, selon un mode de réalisation préféré, sont présentées sur la figure 2 et détaillées dans les paragraphes suivants.

Dans une première étape optionnelle S1, préalablement au procédé, toutes les informations et données de l'environnement réel E, la disposition, le comportement des équipements et de leurs capteurs, sont reçues.

Pour la capture de la connaissance de l'environnement réel E, plusieurs outils et mesures peuvent être employés comme la réalité augmentée, des capteurs de géométrie, plans, fichiers de construction (building information modeling, BIM), etc. Ces données peuvent être par exemple fournies par l'utilisateur, le propriétaire, répertoriées dans des bases de données et/ou par un opérateur se rendant dans l'environnement réel pour la capture directe de certaines informations.

A ces informations peuvent s'ajouter par exemple :
- le type de local, s'il s'agit d'un local professionnel ou d'une habitation domestique,
- la surface du local, sa valeur numérique ainsi que sa forme,
- les espaces fonctionnels dans ladite surface, par exemple s'il s'agit d'une habitation domestique, elle comprend classiquement une chambre, une cuisine et/ou un bureau,
- les types de fonctions des espaces, e.g. dormir, se divertir, cuisiner, et/ou travailler, etc.,
- les informations connues des équipements et capteurs présents dans l'environnement E, particulièrement, leur emplacement, les types d'équipements (équipement électroménager, domotique, etc.) et de capteurs (capteurs de mesures physiques, capteurs d'activation, etc.), leur fonction (chauffage, lumière, etc.) et leur comportement (s'active à l'allumage/l'extinction d'un appareil, ne s'active que sur une plage horaire définie, et/ou en réponse à un changement, etc.),
- les données mesurées par les capteurs et comment celles-ci sont traitées (enregistrées ponctuellement, envoyées à une entité locale ou distante, à un utilisateur, etc.).

En outre, des données de l'état « nominal » ou présent de l'environnement réel E peuvent être utilisées comme référence, telles que les valeurs de températures, pression, humidité, en fonction de la période, les éventuels problèmes répertoriés par un utilisateur/un propriétaire de l'environnement réel (par exemple isolation insuffisante, canalisation percée).

Durant une seconde étape optionnelle S2 préalablement au procédé, toutes les informations obtenues à l'étape S1 sont ensuite utilisées pour initialiser le jumeau numérique J de l'environnement réel E. Le jumeau numérique n'est alors pas uniquement une reproduction géométrique de l'environnement, il comprend l'ensemble des données d'état physique, de comportement, des meubles et/ou des équipements, ainsi que la manière dont ces équipements sont utilisés.

Alternativement, le jumeau numérique J peut être directement reçu, sans mettre en œuvre les étapes S1 et S2. Par exemple, le jumeau numérique J peut contenir des données structurées sous forme de graphe (e.g. formats XML, JSON) ainsi que les informations de modèles 3D associés à ses éléments (tels que les meubles) et les données permettant de modéliser le comportement des équipements et capteurs. Toutes ou parties des données, et/ou du jumeau numérique peuvent être transmis par des fournisseurs (d'électricité, d'internet, d'eau, etc.) qui se baseraient également sur un jumeau numérique de l'environnement réel, par exemple pour leur propre suivi de consommation.

Une simulation 3D est ensuite instanciée à partir du jumeau numérique J (par exemple à l'aide d'un moteur 3D, tel qu'Unity 3D ou Unreal Engine) et représente une réplique numérique de l'environnement et de ces équipements, dans lequel un agent virtuel 3D (ou agent autonome) peut évoluer et interagir.

Un exemple de la reproduction 3D à partir d'un jumeau numérique J de l'environnement réel E de la figure 1 est présenté sur la figure 5, où la pièce Pc1, tous les équipements eq1, 11, 12, p1, p2, mv et leur capteur C1... C6 sont reproduits, avec les répliques d'équipements Req1, RI1, RI2, Rp1, Rp2 et les répliques des capteurs RC1... RC6, dans la réplique de pièce RPc1.

Une fois le jumeau numérique J établi et sa reproduction 3D instanciée, une étape S3 est mise en œuvre. Dans celle-ci, des paramètres utilisateurs sont choisis et utilisés pour générer un ou plusieurs agents autonomes A1, A2, qui doivent ensuite évoluer dans le jumeau numérique J instancié en 3D. Le ou Les agents autonomes sont définis pour reproduire le comportement d'humains évoluant dans l'environnement réel et interagissant avec les équipements de manière automatique. De plus, le ou les agents autonomes peuvent évoluer de manière libre ou au moins partiellement libre, afin de reproduire un comportement général d'un utilisateur donné.

Deux exemples sont illustrés à la figure 3 et présentent un agent autonome A1 dans une simulation 3D basée sur un jumeau numérique J_{A}, J_{B}, reproduisant l'activité d'un utilisateur dans un environnement réel ; dans une cuisine en train de préparer à manger (figure 3A) et dans un bureau en train de travailler (figure 3B).

Pour obtenir une reproduction du comportement la plus fidèle possible, l'agent autonome A1 est paramétré préférentiellement selon un profil utilisateur du ou des utilisateurs de l'environnement réel. Un tel profil utilisateur peut alors comprendre un ensemble d'informations propres aux utilisateurs, établies préalablement.

Par exemple, et sans se limiter à la liste suivante, le profil utilisateur peut comprendre l'âge, le sexe, les compétences/aptitudes, le travail ou type de travail, les humeurs, les centres d'intérêt, les heures et types d'activité préférentielles ou toute autre information pertinente, et non intrusive du ou des utilisateurs.

Quels que soient les paramètres utilisés pour établir le profil utilisateur pour initialiser l'agent autonome, il est recherché dans la présente divulgation de pouvoir identifier rapidement un comportement d'un utilisateur physique UT.

Cette identification du comportement de l'utilisateur UT peut être ensuite analysée afin de déterminer si la sécurité ou l'état de l'utilisateur physique se dégradent par rapport à un comportement considéré comme habituel et/ou une situation considérée comme sûre.

Alternativement ou en complément, il est également possible d'analyser ou de détecter l'activité en cours de l'utilisateur, d'évaluer sa disponibilité, de prédire ses activités futures et/ou de localiser automatiquement la pièce dans laquelle il se trouve. Ces mesures peuvent, par exemple, être utilisées pour adapter les services de l'environnement réel, comme ajuster la température des pièces, couper l'alimentation en gaz en cas d'absence de l'utilisateur, activer une alarme anti-intrusion, permettre les appels téléphoniques avec sonnerie lorsque l'utilisateur est identifié comme disponible, etc.

Un comportement de l'utilisateur ne mettant pas sa sécurité en péril est par exemple manger, dormir, travailler, etc. Il peut également être adapté à un utilisateur spécifiquement, tel que « l'utilisateur dort trois heures par nuit », ou « travaille parfois le dimanche ». A l'inverse, un comportement qui pourrait mettre la sécurité de l'utilisateur en péril serait par exemple « chuter au sol », « ne pas manger », « laisser une arrivée de gaz ouverte », etc. La nature de la situation, sûre ou dangereuse, peut dépendre à la fois du comportement de l'utilisateur et de l'état de l'environnement (par exemple température anormale, fuite d'eau), ou être indiquée par défaut (situation « incendie »). Toute disposition pertinente est à considérer pour améliorer l'identification du comportement et de la situation.

Chaque type de comportement et situation peut être implémenté préalablement, durant l'instanciation de la simulation 3D, ou durant la paramétrisation de l'agent autonome A1. Alternativement ou en combinaison, des comportements habituels/inhabituels et situations sûres/dangereuses peuvent être appris par l'algorithme d'IA après plusieurs jours ou semaines d'implémentation du procédé dans l'environnement réel, tel que décrit ci-dessous dans les étapes S8 à S10 du procédé.

En outre, si cela peut être pertinent pour garantir la sécurité d'un utilisateur, et avec le consentement de l'utilisateur, en plus des exemples de paramètres décrits ci-dessus il peut être prévu de paramétrer le profil utilisateur à partir de données plus intrusives, telles que des données médicales, dans le but d'améliorer sa prise en charge rapide en cas d'un comportement dangereux ou d'une situation à risque. Par exemple, un utilisateur qui serait atteint d'épilepsie qui connaitrait un comportement type durant une crise d'épilepsie (e.g. l'utilisateur est couché au sol hors du lit ou du canapé et hors des périodes de sommeil ou de sieste, indiquant une potentielle crise ou perte de connaissance), pourrait indiquer des données médicales et/ou la nature de comportements dangereux. Dans un tel cas, il ne serait pas tenu de renseigner des informations d'identification personnelle.

Par ailleurs, dans le cas où plusieurs agents autonomes sont définis, d'autres paramètres d'interaction peuvent être considérés, comme par exemple un lien de parenté, des interactions préférentielles, etc. A titre d'exemple, dans le cas d'agents autonomes reproduisant deux utilisateurs parents avec un enfant, les agents autonomes parents peuvent ainsi être paramétrés pour surveiller et/ou s'occuper de l'agent autonome enfant durant des périodes définies, ou pour se coucher dans des pièces distinctes et à des heures différentes.

Selon un mode de réalisation préféré, et afin de reproduire le plus fidèlement possible le comportement d'un utilisateur, l'agent autonome peut en outre être initialisé avec un « modèle de besoins », défini pour reproduire les besoins d'un utilisateur humain, et notamment les besoins de l'utilisateur physique UT.

Un tel modèle de besoins peut alors comprendre, selon un mode de réalisation, une pluralité de jauges de besoins, augmentant chacune, et de manière individuelle, progressivement dans le temps et/ou en fonction des activités de l'agent autonome et/ou en fonction du profil utilisateur. Ces jauges de besoins sont configurées pour créer une urgence à accomplir certaines activités, dites « de besoins », par l'agent autonome A1 dans la simulation 3D du jumeau numérique J.

Une « décision » peut être prise par l'agent autonome en fonction de son modèle de besoins pour évoluer dans la réplique d'environnement. La décision prise par l'agent autonome lui impose son activité. Par exemple si une jauge de besoin est élevée, l'agent autonome peut décider de procéder à ce besoin, ou continuer son activité en cours, ou interagir d'une certaine façon avec son environnement. De cette façon, la simulation de l'agent autonome est affinée et permet d'obtenir un comportement plus réaliste, en outre la simulation est ainsi entièrement automatisée.

Une telle décision de l'agent autonome peut être paramétrée par exemple selon une priorité, de manière probabiliste/aléatoire, et/ou déterministe. Par exemple, dans le cas d'une priorité, il peut être décidé que la jauge de besoins (par exemple « faim ») ne peut pas empêcher l'agent autonome de terminer une activité particulière (par exemple « dormir ») durant un temps prédéfini ou équivalent. De même, dans le cas aléatoire, la décision peut être prise de procéder au besoin selon une probabilité prédéfinie, et dans le cas déterministe la décision peut être prise de procéder au besoin selon des conditions prédéfinies (par exemple l'agent autonome prend la décision de manger dès que la jauge lui impose et s'il est présent à son domicile).

La figure 4 présente un exemple de visualisation de l'activité de l'agent autonome en fonction de son modèle de besoins. Dans cet exemple illustré et à titre non exhaustif, le modèle de besoins peut intégrer une jauge de « soif » (« thirst »), qui augmente de manière linéaire dans le temps, et/ou de manière accrue pendant une activité sportive ou une action de restauration par exemple. Quand la jauge de soif augmente au-delà d'un seuil critique prédéfini (sur la figure 4 celui-ci est établi à 60% de la jauge), l'agent autonome A1 est configuré pour se servir à boire. Lorsque l'agent autonome a bu, la jauge de soif diminue, et l'agent peut reprendre ses autres activités et continuer à interagir avec les autres équipements du jumeau numérique J.

En outre, selon un mode de réalisation, l'agent autonome A1 peut aussi être paramétré en fonction d'un planning d'activités préétabli (non illustré). Le planning d'activités peut contrôler les actions et types d'activités de l'agent autonome A1 sur des plages horaires définies en amont.

Les techniques de simulation s'appuyant sur un planning d'activités peuvent implémenter classiquement des algorithmes d'intelligence artificielle de type Large Language Model (LLM) pour générer des comportements et activités.

Les activités imposées par le planning sont préférentiellement des « activités de vie » de l'utilisateur qui ne sont pas des activités de besoins, telles que travailler, sortir faire des courses, faire une activité sportive, etc. Par exemple, un agent autonome peut être paramétré pour travailler du lundi au vendredi de 8 à 19 heures et est alors considéré « absent » sur ces plages horaires.

De plus, les activités de besoins peuvent être indépendantes et interrompre les activités de vie du planning d'activité ; par exemple, l'agent autonome peut interrompre sa journée de travail pour aller se restaurer.

L'agent autonome A1 (ou les agents autonomes) défini selon les paramètres décrits ci-dessus est ensuite intégré dans la simulation 3D instanciée à partir du jumeau numérique J, durant une étape S4 de la figure 2.

Dans cette étape S4, des paramètres d'initialisation peuvent être définis qui seront utilisés pour une étape S5 de simulation d'activité, comme par exemple la durée cible de la simulation d'activité (e.g. en jours, semaines ou mois), la période de l'année (pour tenir compte de périodes de congés, définir une température moyenne, une heure de lever du soleil etc.), un pas de temps/une résolution de la simulation, etc.

A l'étape S5, l'activité Act.A1 de l'agent autonome A1 est simulée dans le jumeau numérique J instancié en 3D à l'étape S2. Cette simulation d'activité consiste à laisser l'agent autonome évoluer dans la simulation en 3D du jumeau numérique J, en respectant son planning d'activités et ses besoins définis à l'étape S3.

Par exemple, la simulation d'activité peut être intégrée au moteur 3D (Unity3D, Unreal Engine, etc.), utilisé pour instancier le jumeau numérique en 3D. Elle peut être mise en œuvre par plusieurs modes d'interaction avec les répliques d'équipements et avec l'environnement simulé. Cela peut inclure par exemple un mode de cinématique directe (avec des banques d'animations, pour se coucher, s'asseoir, etc.), un mode de cinématique inverse (animation de l'agent autonome en fonction de l'interaction et adaptée avec un objet particulier), et/ou un mode de planification de mouvement (« path planning », où l'agent autonome se déplace en prenant un chemin optimal et en évitant les obstacles), etc.

Selon un mode de réalisation, une part de son activité peut être « libre » régie par ses besoins, et une autre part de son activité est « imposée » par son planning d'activités. Dans une telle configuration, l'agent autonome A1 ne se comporte alors pas de la même façon d'une simulation à l'autre, même pour un même jumeau numérique J.

Toute l'activité de l'agent autonome peut également être imposée préalablement à la simulation, par exemple à partir du planning d'activités. Alternativement, il est possible d'élaborer une liste d'activités sur des plages horaires données, dans laquelle l'agent autonome A1 sélectionne ses actions, aléatoirement ou selon un ordre choisi.

En outre, afin de simuler le plus efficacement des situations réelles, potentiellement dangereuses et des comportements inhabituels de l'agent, il est possible d'imposer une ou des actions/inactions à l'agent autonome A1 et/ou à la simulation 3D du jumeau numérique J, qui pourraient mettre en péril la sécurité. Par exemple, il pourrait être imposé à l'agent autonome A1 de ne pas se restaurer pendant plusieurs jours, ou simuler une situation dangereuse incontrôlée comme une inondation ou un incendie dans la simulation 3D du jumeau numérique J.

La simulation de l'activité Act.A1 de l'agent autonome A1 est itérée avantageusement sur l'équivalent de plusieurs semaines, en accéléré, préférentiellement en quelques heures réelles en fonction des ressources calculatoires à disposition.

Selon un mode de réalisation, la simulation est alors accélérée d'un facteur de préférence 10 à 20 par rapport au temps réel et il est possible de faire des sauts temporels (par exemple lorsque l'agent autonome A1 dort ou est absent) ; ainsi, de préférence, une journée réelle de calcul équivaut à une simulation d'activité de 3 semaines. Pour accélérer d'autant plus la simulation, il est aussi possible de prévoir plusieurs cœurs de calcul parallélisés entre eux.

La figure 5 illustre un exemple de simulation de l'activité Act.A1 de l'agent autonome A1 interagissant avec la réplique de téléviseur Req1 et avec les différentes répliques d'équipements RI1, RI2, Rp1, Rp2, Rmv et leurs capteurs RC1 à RC6, de la réplique de la pièce RPc1 du jumeau numérique J reproduisant l'environnement de la figure 1.

La figure 6 illustre un autre exemple de simulation d'activités Act.A1 et Act.A2 de deux agents autonomes A1, A2, interagissant dans une autre simulation 3D basée sur un autre jumeau numérique J2, reproduisant un autre environnement réel (non illustré), avec la pièce RPc1 et deux pièces supplémentaires RPc2 et RPc3, et une pluralité d'équipements, avec des répliques de robinets/d'arrivées d'eau Rae1, Rae2, d'un réfrigérateur Req2, d'un radiateur Req3, d'un luminaire RI3, d'une alimentation électrique Rec, etc. et leurs capteurs RC7 à RC12.

Dans une étape S6, des données synthétiques annotées sont générées, comprenant les mesures captées par les répliques de capteurs du jumeau numérique J durant la simulation d'activité de l'étape S5, ainsi que les données relatives à la simulation de l'activité en elles-mêmes, i.e. sans nécessairement avoir activé de capteurs.

Ces données, captées et d'activité, sont automatiquement labélisées durant la simulation (labels sur le type d'activité, la pièce dans laquelle se trouve l'agent, la durée de l'activité...) et constituent des données synthétiques d'entraînement, qui seront ensuite utilisées pour entraîner l'algorithme d'IA à intégrer dans l'environnement réel.

De manière non exhaustive, ces données d'entraînement peuvent ainsi comprendre :
- les données de simulation d'activité de l'agent autonome A1, ainsi que les labels et les informations relatives au type d'activité, au temps ou durée de l'activité, à son nombre d'occurrences au cours d'une journée ou d'une période définie,
- les mesures captées par les répliques de capteurs, par exemple, si l'agent autonome A1 s'est déplacé dans la pièce pour aller se servir à boire, il a pu activer une réplique de robinet ainsi qu'un capteur d'ouverture d'eau reliée, et la réplique de capteur de mouvement Rmv sur son passage, et/ou
- les mesures captées de l'état de la simulation 3D du jumeau numérique J, la température ambiante d'une pièce, la luminosité, etc.

Optionnellement et en plus des données d'entraînement générées durant l'étape S5, des données annotées apportées d'une autre simulation (notamment avec un jumeau numérique semblable et un ou des agents autonomes similaires), ou bien des données réelles de l'environnement réel apportées par un opérateur/un utilisateur, peuvent être implémentées pour l'entraînement de l'algorithme d'IA. Optionnellement encore, l'ensemble des données d'entraînement peuvent être traitées durant l'étape S6 pour être converties dans un format désiré, adapté à l'algorithme d'IA visé, de manière automatisée et/ou par un utilisateur.

A l'étape S7, l'algorithme d'IA est entraîné, préférentiellement de manière supervisée, à partir de ces données d'entraînement.

L'algorithme d'IA est par exemple un algorithme de classification (e.g. Multilayer Perceptron, Support Vector Machine) et son entraînement peut être par exemple une optimisation statistique avec une validation croisée (e.g. descente de gradients).

Durant l'entrainement de l'algorithme d'IA, l'IA produit une inférence, où le comportement de l'agent autonome A1 est analysé et identifié à chaque activité ou action entreprise par l'agent autonome. Par exemple, l'algorithme d'IA peut identifier si l'activité correspond à « manger », « dormir », « regarder du contenu sur un téléviseur », etc.

Cette inférence peut ensuite être utilisée pour des applications diverses, en fonction du contexte. Dans le cas de l'aide à la surveillance et à la sécurité des utilisateurs, l'inférence peut être utilisée pour identifier si un comportement de l'agent autonome A1 est inhabituel et/ou dangereux, par exemple par rapport à un comportement « moyen » de l'agent autonome.

L'inférence de l'algorithme d'IA peut aussi servir à mesurer la disponibilité de l'agent autonome (s'il peut être « dérangé » par une sonnerie par exemple), ou pour prédire des activités préférées/futures (par exemple pour optimiser un débit internet en fonction des heures d'utilisation d'un routeur internet), détection de présence dans une pièce particulière (par exemple pour activer certains équipements tels qu'une lampe ou un radiateur) ou autres.

Optionnellement, l'efficacité de l'algorithme d'IA ainsi entraîné peut ensuite être évaluée durant une étape S7'. Dans celle-ci, l'algorithme d'IA entraîné est réintégré dans la simulation d'activité de l'agent autonome A1 dans le jumeau numérique J instancié en 3D de l'étape S5.

L'objectif ici est de vérifier que les inférences produites par l'algorithme d'IA entraîné correspondent bien à la simulation d'activité Act.A1 « réelle » de l'agent autonome A1 et à l'activation des répliques de capteurs RC.

Cette étape peut également ou alternativement comprendre la comparaison entre une prédiction par l'algorithme d'IA de l'activité future et l'activité « réelle » future simulée de l'agent autonome A1, et/ou la comparaison entre une mesure de disponibilité calculée par l'algorithme d'IA et la disponibilité « réelle » simulée de l'agent autonome A1.

L'efficacité de l'algorithme d'IA peut par exemple être évaluée par un seuil prédéfini, ou une mesure de précision correspondant au ratio entre le nombre d'inférences produites par l'algorithme d'IA qui sont correctes et le nombre total d'inférences produites.

Dans le cas où la comparaison n'est pas satisfaisante (dans cet exemple, si la mesure de précision est trop faible, inférieure par exemple à un seuil de 80%), que l'inférence produite par l'algorithme d'IA ne correspond pas à la simulation d'activité de l'agent autonome A1 à l'issue de l'étape S7', les données d'entraînement de l'étape S6 peuvent être corrigées.

En détails, le procédé peut alors être mis en œuvre à nouveau à partir de l'étape S3, où l'agent autonome A1 est paramétré différemment, selon un profil utilisateur, un planning d'activités et/ou un modèle de besoins différents, et/ou de nouveaux agents autonomes sont ajoutés à la simulation pour générer de nouvelles données d'entraînement. Les étapes S7 et S7' sont alors mises à nouveau en œuvre à partir de ces nouvelles simulations d'activités, jusqu'à ce que la comparaison lors du test d'efficacité S7' soit satisfaisante (que la mesure de précision soit supérieure au seuil).

De même, dans le cas où la comparaison est satisfaisante à l'issue de l'étape S7', le procédé peut être mis en œuvre à nouveau à partir de l'étape S3, où l'agent autonome A1 est paramétré différemment, et/ou de nouveaux agents autonomes sont ajoutés à la simulation pour générer de nouvelles données d'entraînement dans le but de converger vers le meilleur entraînement possible de l'algorithme d'IA. Il peut en outre être prévu optionnellement de modifier ou d'adapter le jumeau numérique J de l'étape S2, par exemple si un nouvel équipement est installé dans l'environnement réel E.

Pour améliorer l'évaluation de la pertinence des réponses produites par l'algorithme d'IA, la simulation peut (ou peut ne pas) mettre en œuvre une ou plusieurs situation(s) dangereuse(s), telle(s) qu'un incendie et/ou un comportement inhabituel de l'agent autonome A1 durant l'étape S7'.

Une étape S8 de la figure 2 est ensuite implémentée, où l'algorithme d'IA entraîné est intégré dans l'environnement réel E avec le ou les utilisateurs physiques UT dont l'activité est à surveiller.

L'algorithme d'IA peut ainsi par exemple être intégré dans un équipement de l'environnement réel, tel qu'un routeur internet, et/ou dans un équipement d'un réseau étendu (dans « le cloud »).

L'algorithme d'IA entraîné est ainsi configuré pour pouvoir analyser toutes les activités du ou des utilisateurs physiques UT pendant une étape ultérieure S9. Dans celle-ci, à chaque mesure enregistrée par les capteurs des équipements de l'environnement réel E, que ce soit l'activité directe de l'utilisateur UT (allumage plaques chauffantes) ou une activité/donnée indirecte (température élevée dans une pièce par exemple) l'algorithme d'IA infère et identifie le comportement.

Selon un mode de réalisation préféré, l'analyse de l'activité est faite en temps réel et en continu. Mais alternativement il peut être prévu de paramétrer l'analyse d'activité durant des périodes prédéfinies.

L'analyse de l'activité peut comprendre alors une étape finale S10, où l'algorithme d'IA est configuré pour poursuivre son analyse d'activité (aucune action) ou pour générer une alerte en fonction de son inférence et dans les cas suivants par exemple :
- Aucune action : le comportement de l'utilisateur UT est identifié comme habituel, la situation est classifiée comme sûre, et l'état de l'environnement réel E est identifié comme normal ;
- Alerte : le comportement de l'utilisateur UT est identifié comme inhabituel, la situation est classifiée comme dangereuse, et/ou l'état de l'environnement E est anormal.

Selon un mode de réalisation, le type d'alerte générée est paramétré par l'utilisateur préalablement à l'inférence de l'algorithme d'IA de l'étape S9. Le type de l'alerte peut ainsi dépendre du type de comportement et/ou du type de situation dangereuse et/ou en fonction du profil utilisateur, et peut comprendre par exemple :
- contacter les secours d'urgences (pompiers, SAMU, police),
- contacter une personne prédéfinie (un parent, un voisin),
- envoyer un rapport d'alerte avec ou sans action requise à l'utilisateur via un équipement utilisateur comme un téléphone mobile, et/ou
- accomplir une ou plusieurs actions dans l'environnement réel E, tel que déclencher une alarme ou couper l'alimentation d'un équipement.
L'utilisateur peut en outre choisir de paramétrer une durée cible avant de contacter les secours ou une personne, ne pas alerter dans certains cas qu'il choisit, etc.

Les réponses produites par l'algorithme d'IA peuvent être alternativement reçues par un service externe, par exemple un fournisseur de l'environnement réel (fournisseur internet, d'électricité, etc.), et l'analyse de l'activité et/ou la génération de l'alerte et/ou l'action dans l'environnement réel peut être gérée par ce service plutôt que par l'algorithme d'IA.

Quelle que soit l'inférence de l'étape S10, il peut aussi être prévu d'envoyer un rapport d'activité à l'un ou les utilisateurs (temps d'activation d'un téléviseur, heure de coucher...) et/ou de l'état de l'environnement (température, humidité, consommation électrique...) de manière quotidienne par exemple, et/ou envoyer une proposition à l'utilisateur de piloter l'activation ou la désactivation d'un capteur, via un terminal d'utilisateur.

Selon un autre mode de réalisation, l'algorithme d'IA implémenté dans l'environnement réel E à l'étape S8, peut être mis à jour régulièrement, avec de nouvelles données d'entraînement, réelles et/ou simulées selon les étapes S3 à S7/S7' décrites ci-dessus. Cette mise à jour peut avoir lieu spontanément, régulièrement, et/ou sur demande de l'utilisateur.

Par ailleurs, l'utilisateur peut disposer d'une interface, par exemple implémentée dans le terminal d'utilisateur ou dans un dispositif prévu à cet effet, tel qu'un équipement de surveillance ou un équipement domotique, pour paramétrer et piloter l'algorithme d'IA ainsi que les paramètres relatifs à l'élaboration des agents autonomes (ou du jumeau numérique J), tels que décrits ci-dessus.

Le procédé décrit ci-dessus de surveillance d'activité humaine peut en outre être instancié :
- à distance, sur une machine distante tel que le serveur SER (dans le « cloud ») communiquant via le réseau étendu WAN, et recevant les données DAT des capteurs C1...C6 de l'environnement réel, à partir du réseau local LAN et via la passerelle GW ;
- en local, sur l'un des équipements du réseau local LAN de l'environnement réel E, tel qu'un ordinateur connecté ou un terminal d'utilisateur connecté au réseau LAN par exemple.

Ainsi, dans l'un ou l'autre des modes de réalisation « à distance » ou « en local », l'alerte/le rapport générés par l'algorithme d'IA en réponse à l'activité humaine analysée, et/ou l'activation/désactivation d'équipements dans l'environnement réel E peuvent être ainsi effectués localement (auprès d'une unité connectée au réseau local) ou à distance (auprès d'une unité reliée au serveur SER par exemple).

La figure 7 illustre à titre d'exemple un circuit de traitement pour mettre en œuvre le procédé décrit dans la présente divulgation, pouvant comporter :
- la passerelle GW configurée pour recevoir les données DAT captées par les différents capteurs d'équipements (e.g. le téléviseur eq, le luminaire I, l'alimentation électrique ec, le store de fenêtre p, etc.) interconnectés sur le réseau local LAN de l'environnement réel E, et pour les transmettre au réseau étendu WAN ;
- Le réseau étendu WAN configuré pour recevoir et transmettre les données DAT au serveur distant SER ;
- Le serveur distant SER, comprenant une interface de communication COM connectée au réseau étendu WAN, un processeur PROC capable de piloter l'interface de communication COM du serveur, et une mémoire MEM stockant au moins des instructions d'un programme informatique et/ou de l'algorithme d'IA. La mémoire MEM est accessible par le processeur PROC pour mettre en œuvre le procédé ci-avant lorsque le processeur PROC du circuit de traitement exécute les instructions du programme. L'interface COM reçoit également les instructions du processeur PROC, qu'elle transfère ensuite via le réseau WAN et vers le réseau LAN, les instructions pouvant être l'alerte et/ou l'activation/désactivation d'équipements en fonction de l'inférence de l'algorithme d'IA.

## Revendications

1. Procédé de détermination d'une activité humaine dans un environnement comportant au moins un capteur d'utilisation d'au moins un équipement de l'environnement, le procédé comportant un apprentissage par une intelligence artificielle et une inférence de l'intelligence artificielle pour déterminer l'activité humaine dans ledit environnement,
**caractérisé en ce que** le procédé comporte, pour l'apprentissage de l'intelligence artificielle :
- une génération de données d'entrainement de l'intelligence artificielle, à partir d'une simulation d'une activité d'au moins un agent autonome évoluant dans une simulation d'environnement générée à partir d'un jumeau numérique de l'environnement réel et utilisant au moins une réplique numérique dudit équipement.

2. Procédé selon la revendication 1, dans lequel l'inférence de l'intelligence artificielle est mise en œuvre sur la base de données captées pendant l'utilisation dudit au moins un équipement par au moins un utilisateur physique, en connaissance des données d'entrainement acquises à partir d'utilisations simulées de la réplique numérique de l'équipement par ledit au moins un agent autonome.

3. Procédé selon la revendication 2, dans lequel l'au moins un agent autonome utilisé pour la génération des données d'entrainement est choisi en fonction d'un profil de l'au moins un utilisateur physique.

4. Procédé selon l'une quelconque des revendications précédentes, dans lequel le jumeau numérique de l'environnement réel est initialisé préalablement à la génération de données d'entrainement de l'intelligence artificielle,
ledit jumeau numérique étant configuré pour reproduire un état et un comportement de l'environnement réel par la simulation d'environnement dudit environnement réel comprenant la réplique numérique dudit au moins un équipement de l'environnement réel.

5. Procédé selon la revendication 4, dans lequel le jumeau numérique est généré à partir de données de l'environnement réel, parmi au moins :
- un type de local professionnel ou domestique,
- une surface dudit local,
- des espaces fonctionnels dans ladite surface, et des types de fonctions desdits espaces,
- un état dudit local.

6. Procédé selon l'une quelconque des revendications précédentes, dans lequel ledit au moins un équipement de l'environnement réel comprend au moins :
- un capteur d'ouverture et/ou de fermeture d'une arrivée d'eau ;
- un capteur d'une prise connectée ;
- un capteur de présence ;
- un capteur de pression ;
- un capteur d'allumage et/ou d'extinction d'une lumière ;
- un capteur de mouvement de porte, de store, de volet, et/ou de fenêtre ;
- un capteur thermostatique ;
- un capteur d'utilisation d'un appareil électroménager, et/ou ;
- un capteur d'utilisation d'un terminal connecté.

7. Procédé selon l'une quelconque des revendications précédentes, dans lequel ledit au moins un capteur est relié à un réseau local animé par une passerelle connectée à un serveur via un réseau étendu.

8. Procédé selon l'une des revendications précédentes, comportant en outre une étape de contrôle d'efficacité de l'intelligence artificielle,
dans laquelle l'inférence de l'intelligence artificielle est mise en œuvre sur la base de données captées pendant la simulation de l'activité de l'au moins un agent autonome évoluant dans la simulation de l'environnement générée à partir du jumeau numérique de l'environnement réel, en connaissance des données d'entrainement acquises à partir d'utilisations simulées de la réplique numérique de l'équipement par l'au moins un agent autonome,
dans laquelle une comparaison de l'inférence produite par l'intelligence artificielle par rapport à la simulation de l'activité de l'au moins un agent autonome est évaluée, et si la comparaison est supérieure à un seuil prédéfini, lesdites données d'entraînement sont corrigées par rapport auxdites données captées pendant la simulation de l'activité de l'au moins un agent autonome.

9. Procédé selon la revendication 8, dans lequel au moins un nouvel agent autonome est généré en fonction de ladite comparaison supérieure au seuil prédéfini pour générer de nouvelles données d'entraînement de l'intelligence artificielle.

10. Procédé selon l'une des revendications précédentes, comportant une augmentation de vitesse d'évolution de l'au moins un agent autonome dans ladite simulation de l'environnement générée à partir du jumeau numérique, par rapport à une évolution réelle par au moins un utilisateur physique dans l'environnement réel, en vue d'accélérer la simulation d'activité par l'au moins un agent autonome, et de la génération de données d'entrainement.

11. Procédé selon l'une des revendications précédentes, dans lequel chaque agent autonome évolue dans ladite simulation de l'environnement en fonction d'une décision prise par ledit agent autonome à partir d'un modèle de besoins dudit agent autonome.

12. Programme informatique comportant des instructions pour la mise en œuvre du procédé selon l'une des revendications précédentes, lorsqu'elles sont exécutées par un circuit de traitement.

13. Dispositif comportant un circuit de traitement pour la mise en œuvre du procédé selon l'une des revendications 1 à 10.
